# EUROPEAN PATENT APPLICATION

(11) **EP 1 388 899 A2**
(43) Date of publication of application: **11.02.2004**
(21) Application number: 03016696.1
(22) Date of filing: 04.08.2003
(51) Int. Cl.: H01L 39/14, H01L 39/24

(54) **Oxide superconducting wire**

(30) Priority: 06.08.2002 JP 2002229209
(71) Applicant: International Superconductivity Technology Center, The Juridical Foundation, Tokyo 105-0004 (JP); Fujikura Ltd., Tokyo 135-8512 (JP)
(72) Inventor: Muroga, Takemi, Superconductivity Res. Lab., 1-10-13 Shinonome Koto-ku Tokyo 135-0062 (JP); Yamada, Yutaka, Superconductivity Res. Lab., 1-10-13 Shinonome Koto-ku Tokyo 135-0062 (JP); Araki, Takeshi, Superconductivity Res. Lab., 1-10-13 Shinonome Koto-ku Tokyo 135-0062 (JP); Hirabayashi, Izumi, Superconductivity Res. Lab., 1-10-13 Shinonome Koto-ku Tokyo 135-0062 (JP); Izumi, Teruo, Superconductivity Res. Lab., 1-10-13 Shinonome Koto-ku Tokyo 135-0062 (JP); Shiohara, Yuh, Superconductivity Res. Lab., 1-10-13 Shinonome Koto-ku Tokyo 135-0062 (JP); Ijima, Yasuhiro, Koto-ku, Tokyo 135-0062 (JP)
(74) Representative: Schwabe - Sandmair - Marx

(57) **Abstract**

An oxide superconducting wire composed of a metal substrate, an intermediate layer vapor-deposited by an ion beam assisted deposition method (IBAD method) on the metal substrate, a CeO₂ cap layer vapor-deposited on the intermediate layer by the PLD method or another such method, and an oxide superconducting film formed on the cap layer, wherein the thickness of the intermediate layer is no more than 2000 nm, and the thickness of the cap layer is at least 50 nm. The time it takes to form a film by the IBAD method can be shortened, and the orientation of the resulting superconducting film can be improved, by reducing the thickness of the intermediate layer manufactured by the IBAD method as above and increasing the thickness of the cap layer. The oxide superconducting wire can be obtained at low cost and with high critical current density.

## Description

### BACKGROUND OF THE INVENTION

### 1. Field of the Invention

The present invention relates to an oxide superconducting wire, and more particularly relates to an oxide superconducting wire having an intermediate layer between a substrate and an oxide superconducting film.

### 2. Description of the Prior Art

RE-123-based oxide superconductors (REBa₂Cu₃O₇₋ₓ; RE is a rare earth element including yttrium) are considered materials with extremely promising practical applications because they exhibit superconductivity over the temperature of liquid nitrogen, and there has been a great need for some way to work these materials into a wire for use as a conductor in power supply applications.

One method that has been studied for working an oxide superconductor into a wire is to produce a thin tape from a metal that has high strength and good heat resistance and lends itself to working into a wire, and form an oxide superconducting thin film on this metal tape substrate.

An oxide superconductor has electrical anisotropy, wherein the crystals themselves readily conduct electric current in the a and b axial directions of the crystal axis, but not so well in the c axial direction. Therefore, when an oxide superconductor is formed on a substrate, the a axis or b axis must be oriented in the direction in which electric current flows, and the c axis oriented in vertically to the flat surface.

However, the metal tape substrate itself is either amorphous or polycrystalline, and the crystal structure thereof differs greatly from that of an oxide superconductor, so it is difficult to form an oxide superconducting film having the above-mentioned good crystal orientation on this substrate. Also, the thermal expansion coefficient and the lattice constant of the substrate are different from those of the superconductor, which can result in strain being produced in the superconductor or in the oxide superconducting film separating from the substrate, in the course of cooling down to the superconducting critical temperature.

In view of this, what has been done to solve the above problems is to first form an intermediate layer(buffer layer), composed of a material such as MgO, YSZ (yttria stabilized zirconium), or SrTiO₃ whose physical properties such as thermal expansion coefficient and lattice constant are midway between those of the substrate and those of the superconductor, on a metal tape substrate, and then form an oxide superconducting film on this intermediate layer.

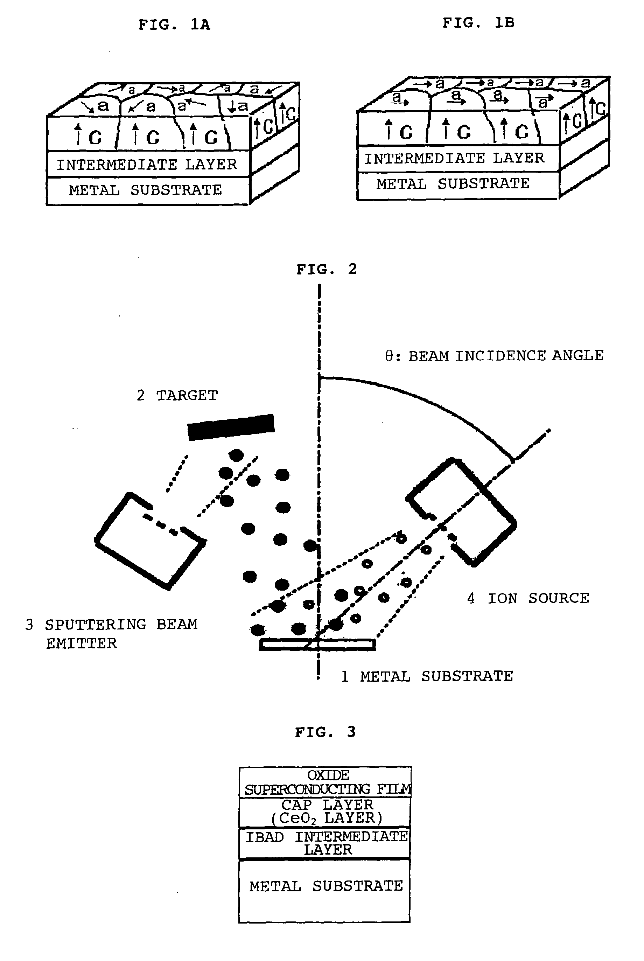

Nevertheless, even when an intermediate layer is formed as above, the resulting oxide superconducting film has such a low critical current density as to be impractical. The reason for this is that the oxide superconducting film is obtained in a state in which numerous single-crystal grains are bonded in the planar direction of the substrate, forming a polycrystalline film, and the c axis of the individual crystal grains is oriented perpendicular to the substrate surface, but the a and b axes are still randomly oriented as shown in Fig. 1A, so crystal orientation is poor.

In view of this, a method for improving crystal orientation has been proposed (see Japanese Patent No. 2,721,595). This method is generally referred to as an IBAD (Ion Beam Assisted Deposition) method, the basics of which are illustrated in Fig. 2.

As shown in Fig. 2, a metal substrate 1 on which a superconducting thin film is to be formed, a target 2 disposed opposite and at an angle to this metal substrate 1, a sputtering beam emitter 3 for sputtering the particles that make up the target 2, and an ion source 4 for obliquely directing ions of a rare gas at the surface of the substrate, are disposed within a vacuum vessel.

The inside of the vessel is evacuated to create a reduced pressure atmosphere, and the ion source 4 and the sputtering beam emitter 3 are actuated. Ions are emitted from the sputtering beam emitter 3 and directed at the target 2, which sputters the particles that make up the target 2 and deposits them on the metal substrate 1, and at the same time, mixed ions comprising rare gas ions and oxygen ions are emitted from the ion source 4 and directed at a specific irradiation angle (θ) at the substrate surface.

Thus sputtering while performing ion irradiation at a specific irradiation angle allows the a and b axes of the crystals in the polycrystalline thin film of the intermediate layer to be oriented.

When an oxide superconducting film is formed by sputtering or laser deposition on an intermediate layer formed as above, the resulting superconducting film is also deposited so as to match the crystal orientation of the intermediate layer, and the crystals of the superconducting film grow in this fashion, so critical current density is large. This state is shown in Fig. 1B.

However, for example, when YBa_{z}Cu₃O_{7-y} (hereinafter also referred to as YBCO) is formed on a YSZ layer formed by the IBAD method as above, barium diffuses from the YBCO layer into the YSZ layer, forming BaZrO₃ on the YSZ layer, which is a problem in that it decreases the critical temperature (Tc) and the critical current density (Jc).

As one method for manufacturing an oxide superconducting film at low cost, there is mentioned a method (TFA-MOD method) in which a solution containing a stoichiometric amount of a trifluoroacetate (TFA) of the metal elements constituting an oxide superconductor is applied onto a substrate surface, and pyrolyzed to create an oxide superconducting film. However, when a YBCO film is formed on a YSZ layer by this method, hydrogen fluoride gas is produced in the course of the heating and decomposition, and this gas reacts with the YSZ, which prevents good superconducting characteristics from being obtained.

A method that has been proposed for solving the above problems involves forming a layer of CeO₂, which is a compound that suppresses the diffusion of barium into the YBCO layer or YSZ layer or the reaction between YSZ and hydrogen fluoride, and which also has a thermal expansion coefficient close to that of YBCO and low reactivity with YBCO, and then forming a YBCO film on this layer. In the present Specification this CeO₂ layer is referred to as a cap layer to distinguish it from the intermediate layer. The following are examples of providing this cap layer.

It is stated in IEEE Transactions on Applied Superconductivity, Vol. 11, No. 1 (March 2001), 2927-2930, that a CeO₂/YSZ/CeO₂/Ni substrate is coated with a solution of a YBCO precursor composed of a metal trifluoroacetate, after which the solution is pyrolyzed, which yields a YBCO film, and the thickness of the CeO₂ film is described to be 20 nm.

It is described in IEEE Transactions on Applied Superconductivity, Vol. 11, No. 1 (March 2001), 3489-3492, that polycrystalline yttrium-iron/garnet (YIG) is used as a substrate, and while no mention of superconducting wire is made, it is said that a buffer layer composed of two layers, namely, a YSZ layer formed by the IBAD method and a CeO₂ layer formed by a pulsed laser deposition method (hereinafter, referred to as "PLD method"), is formed on the YIG substrate, and a YBCO film is formed on this buffer layer, and that the thickness of the YSZ layer is 800 ±100 nm, and the thickness of the CeO₂ layer is about 20 nm.

It is described in J. Mater. Res., Vol. 15, No. 5 (May 2000) that a YSZ layer is formed by the IBAD method on a nickel alloy substrate, and then a CeO₂ layer and a YBCO layer are formed by the PLD method on this, and that the thickness of the CeO₂ layer is 30 nm and the thickness of the YSZ layer is 800 nm.

It is described in IEEE Transactions on Applied Superconductivity, Vol. 11, No. 1 (March 2001), 3359-3364 that a YSZ layer is formed on a nickel alloy substrate by the IBAD method, and first a CeO₂ layer and then a YBCO layer are formed by the PLD method on this, and that the thickness of the YSZ layer is 500 nm and the thickness of the CeO₂ layer is 30 nm.

It is described in Physica C 357-360 (2001), 1003-1006 that a YSZ layer is formed on a Hastelloy tape substrate by the IBAD method, a CeO₂ layer is formed by the PLD method on this, and then a YBCO film is formed by the TFA-MOD method, and that the thickness of the CeO₂ layer is 100 to 2000 nm. (There is no mention of the thickness of the YSZ layer, however.)

Unfortunately, the IBAD method used to form this intermediate layer has the drawback of slow film formation. Further, if a YSZ layer is deposited on a substrate by the IBAD method, the orientation of the film will be inadequate if the film is thin, and the film thickness has to be about 1000 nm for the desired orientation to be achieved. Also, obtaining a film 1000 nm in thickness by the IBAD method takes considerable time, which is a problem in terms of productivity.

### SUMMARY OF THE INVENTION

It is an object of the present invention to shorten the time required by the IBAD method to manufacture a superconducting wire composed of a substrate, an intermediate layer, a cap layer, and an oxide superconducting film, and thereby increase the productivity of superconducting wire.

It is a further object of the present invention to increase the critical current density of an oxide superconducting wire by decreasing the surface roughness and increasing the orientation of the cap layer where the oxide superconducting film is formed.

As a result of diligent research aimed at solving the above problems, the inventors achieved the present invention upon discovering that when a CeO₂ layer is provided as a cap layer on an intermediate layer formed by the IBAD method, even if the intermediate layer is made thinner, as long as the cap layer is made thicker, a superconducting film with good orientation will be obtained.

Specifically, the specific constitution of the present invention for solving the stated problems is as follows.

(1) An oxide superconducting wire composed of a metal substrate, an intermediate layer vapor-deposited by an ion beam assisted deposition method (IBAD method) on the metal substrate, a CeO₂ cap layer vapor-deposited on the intermediate layer, and an oxide superconducting film formed on the cap layer, wherein the thickness of the intermediate layer is no more than 2000 nm, and the thickness of the cap layer is at least 50 nm.

(2) The oxide superconducting wire according to (1) above, wherein the oxide superconducting film is composed of an RE-123-based oxide superconductor (REBa₂Cu₃O₇₋ₓ; RE is a rare earth element including yttrium).

(3) The oxide superconducting wire according to (1) or (2) above, wherein the intermediate layer is composed of a material selected from the group consisting of Gd₂Zr₂O₇, YSZ (yttria stabilized zirconium), and MgO.

(4) The oxide superconducting wire according to any of (1) to (3) above, wherein the thickness of the intermediate layer is at least 10 nm.

(5) The oxide superconducting wire according to any of (1) to (4) above, wherein the orientation (ΔΦ) of the intermediate layer is at least 10 degrees.

(6) The oxide superconducting wire according to any of (1) to (5) above, wherein the orientation (ΔΦ) of the cap layer is better than the orientation (ΔΦ) of the intermediate layer.

(7) The oxide superconducting wire according to any of (1) to (6) above, wherein the thickness of the cap layer is no more than 5000 nm.

(8) The oxide superconducting wire according to any of (1) to (7) above, wherein the orientation (ΔΦ) of the cap layer is no more than 10 degrees.

(9) The oxide superconducting wire according to any of (1) to (8) above, wherein the cap layer is formed by a pulsed laser deposition method (PLD method).

(10) The oxide superconducting wire according to any of (1) to (9) above, wherein the cap layer is formed at a rate higher than a rate at which the intermediate layer is formed.

(11) The oxide superconducting wire according to any of (1) to (10) above, wherein the cap layer is formed at a rate of 1 to 5000 nm/min.

(12) The oxide superconducting wire according to any of (1) to (11) above, wherein the cap layer is formed at a PLD laser energy density of 1 to 5 J/cm².

(13) The oxide superconducting wire according to any of (1) to (12) above, wherein the oxide superconducting film is a Y123 phase, Sm123 phase, or Nd123 phase.

(14) The oxide superconducting wire according to any of (1) to (13) above, wherein the oxide superconducting film is formed by a pulsed laser deposition method (PLD method) or a metal organic deposition method (MOD method).

(15) The oxide superconducting wire according to any of (1) to (14) above, wherein the metal substrate is composed of a material selected from the group consisting of Hastelloy, stainless steel, nickel alloys, silver, and silver alloys.

### BRIEF DESCRIPTION OF THE DRAWINGS

Fig. 1A shows how the a axis of the individual crystal grains constituting an oxide superconducting film is not oriented, and Fig. 1B shows the a axis of the individual crystal grains is oriented.

Fig. 2 is a simplified diagram of the film formation process by the IBAD method.

Fig. 3 is an illustration showing the layer structure of the superconducting wire of the present invention.

Fig. 4 is a graph showing the relationship of ΔΦ to the film thickness of Gd₂Zr₂O₇, and YSZ, and the film formation rate.

Fig. 5 is a graph showing the relationship of IBAD film thickness to the ΔΦ of the CeO₂ layer formed thereon.

Fig. 6 is a graph showing the relationship of IBAD film thickness to the critical current density of the resulting superconducting film.

Fig. 7 is a graph showing the ΔΦ of the CeO₂ film versus the thickness of the CeO₂ film.

Fig. 8 is a graph showing the CeO₂ film formation rate versus the surface roughness (Ra) of the resulting CeO₂ layer.

Fig. 9 is a graph showing the laser energy density versus the crystal orientation ΔΦ of the resulting CeO₂ layer.

### DETAILED DESCRIPTION OF THE PREFERRED EMBODIMENTS

Embodiments of the present invention will now be described.

The superconducting wire of the present invention has the layer structure shown in Fig. 3, consisting of an oxide superconducting film, a cap layer (CeO₂ layer), an IBAD intermediate layer, and a metal substrate.

The materials used to form each of these layer will now be discussed.

### <Substrate Material>

Copper, nickel, titanium, molybdenum, niobium, tantalum, tungsten, manganese, iron, silver, and other such metals and alloys thereof that offer excellent strength and heat resistance can be used as the metal substrate used in the oxide superconducting wire of the present invention. Stainless steel, Hastelloy, and other nickel alloys are particularly favorable because of their superior resistance to corrosion and heat.

### <Intermediate layer>

### [Material]

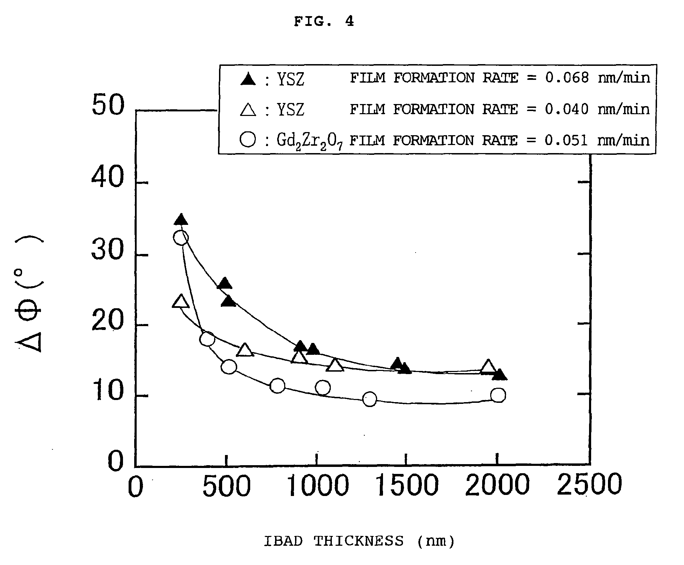

The intermediate layer is formed by the IBAD method. Examples of the material used to form this intermediate layer include YSZ, MgO, SrTiO₃, and Gd₂Zr₂O₇, and it is also possible to use any suitable compound having a pyrochlore structure, rare earth-C structure, perovskite structure, or fluorite structure. Of these, the use of YSZ or Gd₂Zr₂O₇, is preferable. Gd₂Zr₂O₇, is a particularly suitable intermediate layer material because not only is its IBAD film formation rate higher than that of YSZ, but its ΔΦ (FWHM: full width at half maximum), which is an index of orientation, is also smaller. Fig. 4 shows the relationship of ΔΦ to film thickness when films were made from Gd₂Zr₂O₇, and from YSZ. This graph indicates that Gd₂Zr₂O₇, has a higher orientation rate and a smaller ΔΦ than YSZ.

### [Film Thickness]

It has been said in the past that an intermediate layer formed by the IBAD method (hereinafter also referred to as an IBAD film) will not afford good orientation unless it is about 1000 nm thick. The deposition rate by the IBAD method, however, is only about 3 nm/minute, which poses a problem in terms of productivity.

However, if a CeO₂ layer is formed in at least a certain thickness on an IBAD layer, even if the thickness of the IBAD film is no more than 1000 nm, the resulting CeO₂ layer will have good orientation, and when an oxide superconducting film is formed on this CeO₂ layer, this oxide superconducting film will exhibit high critical current density. This CeO₂ layer can be formed by the PLD method, and since the PLD method allows a film to be formed at high speed (5000 nm/minute, for example), even if the IBAD film is made thin and the CeO₂ layer is made thick, there will be a significant increase in the total film formation rate, which affords better productivity.

For the above reasons, the thickness of the intermediate layer in the present invention should be no more than 1000 nm. 1000 nm may be exceeded, but since it takes a long time to form a film by the IBAD method as mentioned above, a film thickness over 1000 nm is undesirable in terms of productivity. Furthermore, exceeding 2000 nm is undesirable because surface roughness will be larger and there will be a decrease in critical current density.

The lower limit to the thickness of the intermediate layer depends on the thickness of the CeO₂ layer, but the thickness should be at least 10 nm, with at least 50 nm being preferable, and at least 100 nm being even better. If the intermediate layer is less than 10 nm thick, then even if a CeO₂ layer is deposited on this intermediate layer, the orientation will be over 10 degrees and the flow of critical current will be inadequate.

### <Cap Layer>

The cap layer consists of a CeO₂ layer. This CeO₂ layer does not need to be composed entirely of CeO₂, and may include a Ce-M-O oxide in which part of the cerium has been replaced with other metal atoms or metal ions. This CeO₂, layer can be formed by the PLD method, sputtering, or another such method, but the use of the PLD method is preferred because the film can be formed faster. The formation of the CeO₂ layer by the PLD method can be carried out under the conditions of a substrate temperature of approximately 500 to 800°C and a laser energy density of 1 to 5 J/cm², in an oxygen gas atmosphere of approximately 0.6 to 40 Pa.

The CeO₂ layer should be at least 50 nm in thickness, but for adequate orientation to be obtained, at least 100 nm is preferable, and at least 500 nm is even better. However, if the thickness exceeds 500 nm, crystal orientation will suffer. Therefore, a thickness of 5000 nm or less is preferred.

### <Oxide Superconducting Film>

An RE-123-based oxide superconductor (REBa₂Cu₃O₇₋ₓ; RE is a rare earth element such as yttrium, lanthanum, neodymium, samarium, europium, or gadolinium) can be used as the material of the oxide superconducting film. The RE-123-based oxide is preferably Y123 (YBa₂Cu₃O₇₋ₓ; hereinafter referred to as YBCO) or Sm123 (SmBa₂Cu₃O₇₋ₓ; hereinafter referred to as SmBCO). The oxide superconducting film can be formed by a standard method, but the use of the TFA-MOD method or the PLD method is preferable in terms of productivity.

Examples of the present invention will now be given along with comparative examples, but the present invention is not limited to or by these examples.

### Example 1

Gd₂Zr₂O₇ films were deposited in various thicknesses by the IBAD method on Hastelloy metal substrates to prepare substrate samples (hereinafter referred to as IBAD substrates). A CeO₂ layers was deposited in a thickness of 500 nm by the ordinary PLD method on each IBAD substrate.

The deposition of the CeO₂ layer by the PLD method was performed at a temperature of approximately 650°C, in an O₂ gas atmosphere of approximately 4 Pa, at a laser energy density of 3 J/cm², and at a laser frequency of 17 Hz. First, a CeO₂ pellet 3 cm in diameter was attached in a vacuum chamber, the inside of which was evacuated, and then the above-mentioned O₂ gas was introduced to adjust the pressure. The pellet was irradiated with a KrF excimer laser, which resulted in a CeO₂ layer being deposited on the IBAD substrate disposed across from the pellet. A YBCO superconducting film was formed in a thickness of 250 nm by the TFA-MOD method (an organometal deposition method using trifluoroacetate, i.e., coating-pyrolysis method).

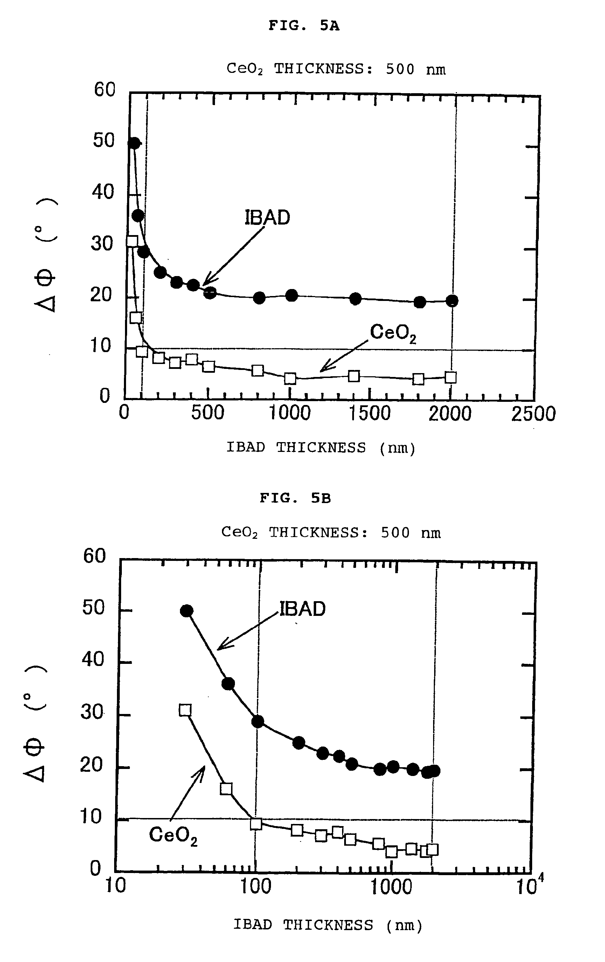

The in-plane orientation (ΔΦ) of each sample was examined by X-ray diffraction. Fig. 5 shows the results of measuring the orientation of the CeO₂ layer formed in a thickness of 500 nm on each of the IBAD-Gd₂Zr₂O₇, films of various thickness. For the sake of comparison, also shown is the orientation when there was no CeO₂ layer, that is, the orientation of just the IBAD-Gd₂Zr₂O, layer. Fig. 5A is a graph of the relationship between the thickness of the IBAD film and ΔΦ, and Fig. 5B is a detail depiction of the data for IBAD thicknesses of 100 to 1000 nm.

It can be seen from the results shown in Fig. 5 that orientation is improved by the deposition of the CeO₂ layer. This effect is particularly pronounced when the thickness of the IBAD layer is no more than 1000 nm. When the CeO₂ layer was deposited in a thickness of 500 nm on IBAD-Gd₂Zr₂O, films 1000 to 2000 nm in thickness, an orientation of 4 degrees was obtained, which is nearly impossible with IBAD alone. A YBCO (YBa₂Cu₃O₇₋ₓ) superconducting layer was formed by the TFA-MOD method on each sample, and the critical current was measured, whereupon a high critical current density of 3 MA/cm² was obtained at 77 K and 0 T.

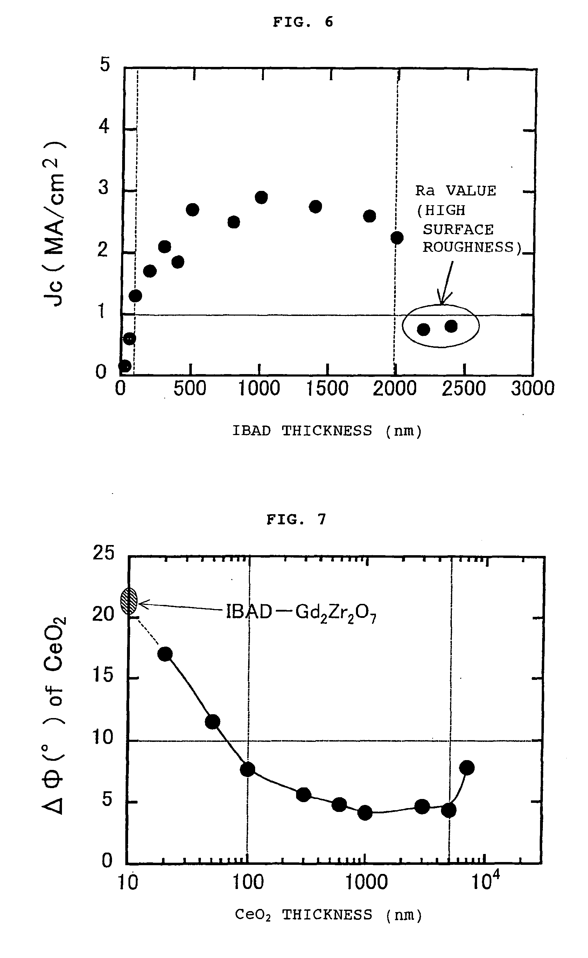

Fig. 6 shows the critical current density for the various samples obtained in this experiment. As is clear from Fig. 6, samples with better orientation exhibited higher critical current density and were more useful for practical application.

Similarly, a CeO₂ oxide layer with a thickness of 500 nm was deposited on each of IBAD-Gd₂Zr₂O₇ layers with a thickness of 2500 and 3000 nm. The surface roughness Ra was measured by AFM (atomic force microscope) over a range of 0.1 × 0.1 mm, which revealed that when the thickness is over 2000 nm, the roughness is not less than 100 nm, which is impractical. Specifically, the critical current density was at least 1 MA/cm², just as above, when the film thickness was not greater than 2000 nm, but when 2000 nm was exceeded, the critical current density dropped significantly to 0.7 MA/cm² because of the increase in surface roughness shown in Fig. 6.

On the other hand, if the thickness of the IBAD layer is under 100 nm and a CeO₂ layer is deposited by the PLD method, the orientation will be over 10 degrees, which prevents adequate critical current from flowing. This is because if the orientation is over 10 degrees, there is insufficient electrical connection (weak bonding) between the YBCO crystals. However, if the thickness of the IBAD layer is at least 100 nm, the orientation of the CeO₂ layer becomes not more than 10 degrees and sufficient current flows. The IBAD method is a slow method, with a deposition rate of only about 3 nm/minute, so the manufacturing time is longer, but the deposition and manufacturing time can be shortened by making the IBAD film thinner and forming the CeO₂ layer thicker by the PLD method as in the present invention.

The results shown in Figs. 5 and 6 show that the above-mentioned IBAD film thickness is preferably no more than 2000 nm, the effect of which is especially pronounced from the standpoint of increasing the manufacturing rate. Specifically, if the IBAD layer thickness is 2000 nm or less, the PLD-CeO₂ layer of this invention will be effective, but the IBAD layer thickness is preferably no more than 1000 nm, with 500 nm or less being even better. Also, in terms of the critical current density and orientation ultimately achieved, the thickness of the IBAD layer is preferable at least 100 nm.

### Example 2

Just as in Example 1, a Gd₂Zr₂O₇, film was deposited in a thickness of 500 nm by the IBAD method on a Hastelloy metal substrate to prepare a number of IBAD substrates. A CeO₂ oxide layer was deposited in various thicknesses by the PLD method. Again, the YBCO was formed by the TFA-MOD method.

Fig. 7 shows the ΔΦ values for various CeO₂ films formed in nine different thicknesses: 20 nm, 50 nm, 100 nm, 300 nm, 600 nm, 1000 nm, 3000 nm, 5000 nm, and 7000 nm.
The smaller is the ΔΦ value, the better the crystal orientation is, but the results shown in Fig. 7 indicate that at 7000 nm (that is, when 5000 nm is exceeded), crystal orientation is slightly worse. ΔΦ is less than 10 degrees at a thickness between 100 and 5000 nm. A YBCO superconducting layer was formed by the TFA-MOD method onto each of these samples in the same manner as in Example 1, and the critical current was measured, which indicated Jc to be at least 1 MA/cm² when the CeO₂ film thickness was 50 to 7000 nm at 77 K and 0 T, and a Jc of at least 2 MA/cm² was obtained between 100 and 5000 nm in particular, with the highest critical current density obtained being 3 MA/cm².

It can be seen from the above results that providing a CeO₂ layer in a thickness of at least 50 nm is very effective. Preferably, to achieve better orientation, this thickness should be at least 100 nm, and it can be seen that a CeO₂ layer with a thickness of at least 500 nm will afford high orientation and a sufficiently large critical current density.

The same test was conducted using YSZ and MgO instead of Gd₂Zr₂O₇ as the above-mentioned IBAD intermediate layer, whereupon the results for the ΔΦ of the CeO₂ layer and the Jc of the YBCO film were the same as before.

### Example 3

The same test as in Example 1 was conducted, except that an SmBCO (SmBa₂CU₃O₇₋ₓ) film was formed instead of the YBCO film used as the superconducting film in Example 1, which yielded results similar to those in Example 1. Jc, however, was slightly lower than when the YBCO film was formed, and reached a maximum of only 2 MA/cm².

### Example 4

The same test as in Example 1 was conducted, except that an NdBCO (NdBa₂CU₃O₇₋ₓ) film was formed instead of the YBCO film used as the superconducting film in Example 1, which yielded results similar to those in Example 1. Jc, however, was slightly lower than when the YBCO film was formed, and reached a maximum of only 2 MA/cm².

### Example 5

The same test as in Example 1 was conducted, except that the thickness of the CeO₂ layer used in Example 1 was changed to 5000 nm. As a result, similarly to Example 1, orientation increased when the CeO₂ layer was deposited. This effect was particularly pronounced when the thickness of the IBAD layer was 1000 nm or less. When the CeO₂ layer was deposited in a thickness of 5000 nm on each of IBAD-Gd₂Zr₂O₇ films 1000 to 2000 nm in thickness, an orientation of 4 degrees (ΔΦ) was obtained, which is nearly impossible with IBAD alone. A YBCO superconducting layer was formed by the TFA-MOD method onto each of these samples, and the critical current was measured, whereupon a maximum critical current density of approximately 3 MA/cm² was obtained at 77 K and 0 T. As in Example 1, these results indicate that samples with better orientation exhibited higher critical current density and were more useful for practical application.

### Example 6

The same test as in Example 1 was conducted, except that stainless steel and a nickel alloy were used instead of the Hastelloy used as the metal substrate in Example 1. Here again, the results for the ΔΦ of the CeO₂ layer and the Jc of the YBCO film were the same as before.

### Example 7

The same test as in Example 1 was conducted, except that the method for manufacturing the YBCO film was changed from the TFA-MOD method to the PLD method, whereupon the results for the ΔΦ of the CeO₂ layer and the Jc of the YBCO film were the same as in Example 1.

### Example 8

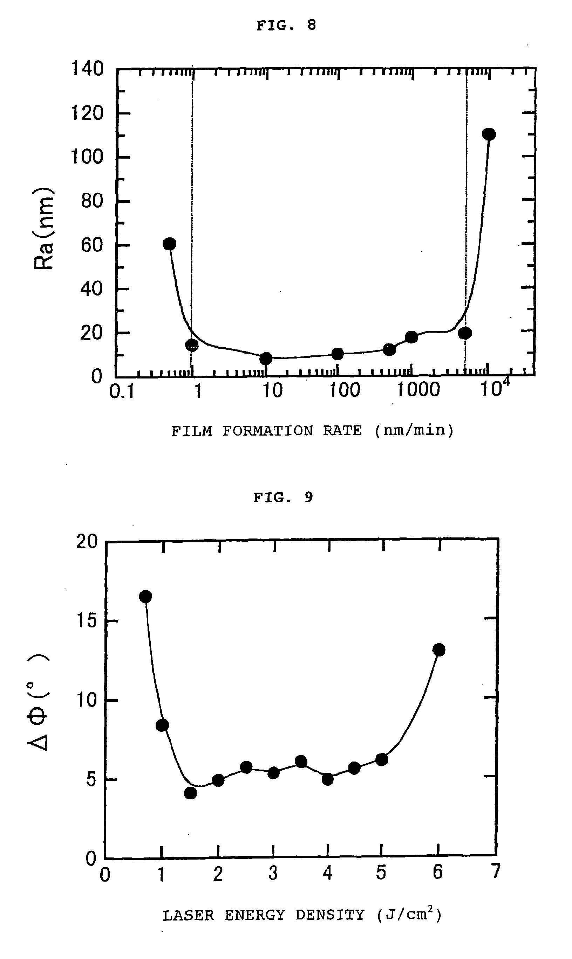

A CeO₂ layer with a thickness of 500 nm was formed by the PLD method on the IBAD substrate used in Example 1 (Gd₂Zr₂O₇, film thickness: 300 nm), such that the film formation rate, based on thickness, was 0.5 to 10,000 nm/minute. Fig. 8 is a graph of the results of measuring the surface roughness (Ra) of the CeO₂ layer obtained at various film formation rates.

Film formation rates of 0.5 and 10,000 nm/minute were impractical because of the large Ra value. On the other hand, Ra was 20 nm or less between 1 and 5000 nm/minute, with the surface in good condition. A YBCO film was formed on each of these samples by the TFA-MOD method in the same manner as in Example 1, and the critical current was measured, which indicated Jc to be at least 1.5 MA/cm² at 77 K and 0 T when the CeO₂ layer was formed at a rate of 1 to 5000 nm/minute. Jc was 3 MA/cm² with a YBCO film on a CeO₂ layer formed at 10 nm/minute.

The present invention is characterized in that the film formation rate is markedly higher than with a conventional IBAD film formation method. Specifically, if the IBAD film formation rate is 3 nm/minute and the CeO₂ layer formation rate is 50 nm/minute, when the CeO₂ layer is formed in a thickness of 100 nm on the IBAD film with a thickness of 2000 nm by a conventional method, the total time required is 668 minutes (2000 (nm) ÷ 3 (nm/minute) + 100 (nm) ÷ 50 (nm/minute) = 668 minutes). In contrast, with the present invention, when a CeO₂ layer of 500 nm is formed on an IBAD film of 300 nm, the total time required is 110 minutes (300 (nm) ÷ 3 (nm/minute) + 500 (nm) ÷ 50 (nm/minute) = 110 minutes).

As discussed above, the oxide superconducting wire of the present invention can be manufactured in less time than with a conventional method, and has the further advantage that its orientation will be the same as or better than a conventional wire, as shown in Figs. 5 and 7.

### Example 9

A CeO₂ layer was formed at a laser energy density of 0.7 to 6 J/cm² by the PLD method on the IBAD substrate used in Example 1 (Gd₂Zr₂O, film thickness: 300 nm). The CeO₂ layer thickness was 500 nm. Fig. 9 is a graph of the results of measuring the crystal orientation ΔΦ at various laser energy densities. Levels of 0.7 and 6 J/cm² were impractical for the reason given in Example 1, since ΔΦ was over 10 degrees in these cases. ΔΦ was not more than 10 degrees between 1 and 5 J/cm².

A YBCO superconducting layer was formed on each of these samples by the TFA-MOD method in the same manner as in Example 1, and the critical current was measured, which indicated Jc to be at least 1 MA/cm² at 77 K and 0 T on a CeO₂ layer formed at 1 to 5 J/cm². In particular, with a YBCO film on a CeO₂ layer formed at 1.5 to 4 J/cm², Jc was at least 2 MA/cm², and the maximum Jc was 3 MA/cm² with a YBCO film on a CeO₂ layer formed at 1.5 J/cm², just as in Example 1.

The present invention allows the IBAD film of the intermediate layer to be made thinner, so the IBAD method takes less time and the productivity of superconducting wire is higher. Also, increasing the thickness of the CeO₂ layer provided as the cap layer reduces the surface roughness of the CeO₂ layer and affords a surface of higher orientation, so when an oxide superconducting film is formed on this surface, a superconducting film of higher critical current density can be obtained.

## Claims

1. An oxide superconducting wire composed of a metal substrate, an intermediate layer vapor-deposited by an beam assisted deposition method (IBAD method) on the metal substrate, a CeO₂ cap layer vapor-deposited on the intermediate layer, and an oxide superconducting film formed on the cap layer, wherein the thickness of the intermediate layer is no more than 2000 nm, and the thickness of the cap layer is at least 50 nm.

2. The oxide superconducting wire according to Claim 1, wherein the oxide superconducting film comprises an RE-123-based oxide superconductor (REBa₂Cu₃O₇₋ₓ; RE is a rare earth element including yttrium).

3. The oxide superconducting wire according to Claim 1 or 2, wherein the intermediate layer is composed of a material selected from the group consisting of Gd₂Zr₂O₇, YSZ (yttria stabilized zirconium), and MgO.

4. The oxide superconducting wire according to any of Claims 1 to 3, wherein the thickness of the intermediate layer is at least 10 nm.

5. The oxide superconducting wire according to any of Claims 1 to 4, wherein the orientation (ΔΦ) of the intermediate layer is at least 10 degrees.

6. The oxide superconducting wire according to any of Claims 1 to 5, wherein the orientation (ΔΦ) of the cap layer is better than the orientation (ΔΦ) of the intermediate layer.

7. The oxide superconducting wire according to any of Claims 1 to 6, wherein the thickness of the cap layer is no more than 5000 nm.

8. The oxide superconducting wire according to any of Claims 1 to 7, wherein the orientation (ΔΦ) of the cap layer is no more than 10 degrees.

9. The oxide superconducting wire according to any of Claims 1 to 8, wherein the cap layer is formed by a pulsed laser deposition method (PLD method).

10. The oxide superconducting wire according to any of Claims 1 to 9, wherein the cap layer is formed at a rate higher than a rate at which the intermediate layer is formed.

11. The oxide superconducting wire according to any of Claims 1 to 10, wherein the cap layer is formed at a rate of 1 to 5000 nm/min.

12. The oxide superconducting wire according to any of Claims 1 to 11, wherein the cap layer is formed at a PLD laser energy density of 1 to 5 J/cm².

13. The oxide superconducting wire according to any of Claims 1 to 12, wherein the oxide superconducting film is a Y123 phase, Sm123 phase, or Nd123 phase.

14. The oxide superconducting wire according to any of Claims 1 to 13, wherein the oxide superconducting film is formed by a pulsed laser deposition method (PLD method) or a metal organic deposition method (MOD method).

15. The oxide superconducting wire according to any of Claims 1 to 14, wherein the metal substrate is composed of a material selected from the group consisting of Hastelloy, stainless steel, nickel alloys, silver, and silver alloys.
